(19) Europäisches Patentamt
European Patent Office
Office européen des brevets

(11) EP 3 840 060 B1

(12) **FASCICULE DE BREVET EUROPEEN**

(45) Date de publication et mention de la délivrance du brevet:
**12.06.2024 Bulletin 2024/24**

(21) Numéro de dépôt: **20215120.5**

(22) Date de dépôt: **17.12.2020**

(51) Classification Internationale des Brevets (IPC):
***H01L 31/0236*** *(2006.01)* ***H01L 31/068*** *(2012.01)*
***H01L 31/18*** *(2006.01)* ***H01L 31/0725*** *(2012.01)*
***H01L 31/0747*** *(2012.01)* *H01L 31/20 (2006.01)*
*H01L 21/306 (2006.01)*

(52) Classification Coopérative des Brevets (CPC):
**H01L 31/02363; H01L 31/068; H01L 31/0725; H01L 31/0747; H01L 31/1804;** Y02E 10/547; Y02P 70/50

(54) **PROCÉDÉ DE FORMATION DE MOTIFS À LA SURFACE D'UN SUSBTRAT EN SILICIUM CRISTALLIN**

VERFAHREN ZUR MUSTERBILDUNG AUF DER OBERFLÄCHE EINES KRISTALLINEN SILIZIUMSUBSTRATS

METHOD FOR FORMING PATTERNS ON THE SURFACE OF A SILICON CRYSTALLINE SUBSTRATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.12.2019 FR 1914778**

(43) Date de publication de la demande:
**23.06.2021 Bulletin 2021/25**

(73) Titulaire: **Commissariat à l'Energie Atomique et aux Energies Alternatives**
**75015 Paris (FR)**

(72) Inventeur: **LIGNIER, Hélène**
**38054 GRENOBLE CEDEX 09 (FR)**

(74) Mandataire: **Cabinet Camus Lebkiri**
**25 rue de Maubeuge**
**75009 Paris (FR)**

(56) Documents cités:
**EP-A2- 2 458 622**
**WO-A1-2013/055290**
**WO-A1-2013/089641**
**FR-A1- 3 034 255**
**US-A- 4 137 123**
**US-A1- 2011 277 827**
**US-A1- 2012 112 321**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 840 060 B1

## Description

### DOMAINE TECHNIQUE DE L'INVENTION

La présente invention se rapporte à la structuration d'un substrat en silicium cristallin, par exemple dans le but de fabriquer une cellule photovoltaïque en silicium. Plus précisément, l'invention concerne un substrat en silicium cristallin comprenant une surface structurée, une cellule photovoltaïque comprenant un tel substrat, un procédé de formation de motifs à la surface d'un substrat en silicium cristallin et un procédé de fabrication d'une cellule photovoltaïque.

### ARRIERE-PLAN TECHNOLOGIQUE DE L'INVENTION

La figure 1 représente une cellule photovoltaïque à homojonction à base de silicium cristallin connue de l'état de la technique, notamment des documents [« Passivated rear contacts for high-efficiency n-type Si solar cells providing high interface passivation quality and excellent transport characteristics », F. Feldmann et al., Solar Energy Materials & Solar Cells, Vol. 120, pp. 270-274, 2014] et [« The irresistible charm of a simple current flow pattern-25% with a solar cell featuring a full-area back contact», S. W. Glunz et al., Proceedings of the 31 st European Photovoltaic Solar Energy Conférence and Exhibition, pp. 259-263, 2015]. Cette cellule photovoltaïque, dite de seconde génération, comporte :

- un substrat 10 en silicium cristallin dopé de type n comprenant une première surface 10a dite face avant, destinée à être exposée à un rayonnement solaire incident, et une deuxième surface 10b dite face arrière, opposée à la première surface ;
- une couche d'oxyde 11 (appelé oxyde tunnel) d'épaisseur très faible (typiquement inférieure à 1,5 nm) recouvrant la face arrière 10B du substrat 10 ;
- une couche de silicium polycristallin dopé 12 disposée sur la couche d'oxyde 11 ;
- une première électrode 13, par exemple en argent, disposée sur la couche de silicium polycristallin dopé 12 et recouvrant l'intégralité de la face arrière 10B du substrat 10 ;
- une couche émetteur 14 en silicium dopé de type p disposée sur la face avant 10A du substrat 10 :
- une couche de passivation 15, par exemple en alumine ($Al_2O_3$), disposée sur la couche émetteur 14 ; et
- un revêtement antireflet 16, par exemple en nitrure de silicium (SiN), disposé sur la couche de passivation 15 ; et
- une pluralité de deuxièmes électrodes 17 appelées « doigts de collecte » en contact avec la couche émetteur 14 à travers la couche de passivation 15 et le revêtement antireflet 16.

L'empilement comprenant la couche d'oxyde tunnel 11, la couche de silicium polycristallin dopé 12 et la première électrode 13 forme une structure de contact passivé appelée communément « TOPCon » (« Tunnel Oxide Passivated Contact » en anglais). Cette structure de contact passivé augmente les performances de la cellule photovoltaïque, notamment la tension de circuit ouvert (Voc) et le rendement de conversion photovoltaïque.

La face avant 10A du substrat 10 est texturée afin d'augmenter la quantité de photons captés par le substrat. Cette texturation de surface se présentent généralement sous la forme de pyramides comprenant une base carrée et des flancs inclinés par rapport à la base d'un angle égal à 54,7° environ. Par ailleurs, les sommets des pyramides sont très abrupts (rayon de courbure inférieur à 30 nm), ce qui rend difficile l'obtention de couches d'épaisseur constante sur la surface texturée. La texturation sous forme de pyramides est classiquement obtenue par une étape de gravure anisotrope à l'aide d'une solution alcaline, telle qu'une solution d'hydroxyde de potassium (KOH) ou d'hydroxyde de sodium (NaOH).

La face arrière 10B du substrat 10 est au contraire polie pour obtenir une bonne passivation de surface. Le polissage de la face arrière du substrat peut être réalisée par voie chimique, en milieu acide ou basique.

Pour rendre bifaciale la cellule photovoltaïque de la figure 1, c'est-à-dire pour lui permettre de capter par la face arrière 10B un rayonnement solaire réfléchi ou diffus, la métallisation « pleine plaque » (première électrode 13) disposée sur la face arrière 10B du substrat doit être remplacée par une pluralité d'électrodes discrètes comme celles disposées sur la face avant 10A texturée (deuxièmes électrodes 17). Or ces électrodes étroites, généralement obtenues par sérigraphie d'une pâte d'argent, présentent des défauts d'adhésion sur les surfaces polies qui sont peu rugueuses (contrairement aux surfaces texturées sous forme de pyramides). Ce manque d'adhésion peut conduire à des arrachements des électrodes lorsque la cellule photovoltaïque est ensuite manipulée, et donc à une diminution importante du rendement de conversion photovoltaïque. US 2012/112321 A1 et WO 2013/055290 A1 décrivent certains procédés de formation de motifs à la surface d'un substrat de silicium, connus dans l'état de l'art.

## RESUME DE L'INVENTION

Il existe donc un besoin de former une surface présentant de bonnes propriétés de passivation et permettant une bonne prise de contact. L'objet de la présente invention est défini dans la revendication 1.

Selon un premier aspect de l'invention, on tend à satisfaire ce besoin en prévoyant un procédé de formation de motifs à la surface d'un substrat en silicium cristallin, le procédé comprend une étape de structuration consistant à immerger la surface du substrat dans un bain de gravure comprenant une solution aqueuse d'hydroxyde de potassium (KOH). La concentration massique en hydroxyde de potassium (KOH) du bain de gravure est comprise entre 0,95 % et 1,05 %, la température du bain de gravure est comprise entre 60 °C et 80 °C et la durée d'immersion est comprise entre 8 minutes et 12 minutes.

La surface du substrat ainsi structurée présente une faible réflectivité, intermédiaire entre celle d'une surface polie et celle d'une surface texturée sous forme de pyramides, et des propriétés de passivation aussi bonnes que celles d'une surface polie. En outre, la surface structurée du substrat en silicium cristallin permet la formation d'électrodes ayant une faible résistivité de contact et une bonne adhérence, semblables à celles obtenues avec une surface texturée sous forme de pyramides.

Le procédé de formation de motifs selon le premier aspect de l'invention peut présenter une ou plusieurs caractéristiques complémentaires parmi les suivantes, considérées individuellement ou selon toutes les combinaisons techniquement possibles :

- le procédé comprend, avant l'étape de structuration, une étape de gravure d'une zone écrouie présente à la surface du substrat ;
- la durée d'immersion est en outre choisie de sorte à graver simultanément une zone écrouie présente à la surface du substrat ; et
- le bain de gravure comprend un surfactant de concentration volumique comprise entre 1,9 % et 2,2 %.

Un deuxième aspect de l'invention concerne un procédé de fabrication d'une cellule photovoltaïque, comprenant une étape de formation de motifs à la surface d'un substrat en silicium cristallin par mise en oeuvre d'un procédé de formation selon le premier aspect de l'invention.

De préférence, le procédé de fabrication comprend en outre une étape de dépôt d'une couche mince sur la surface du substrat, par exemple une couche d'oxyde de silicium ultra-mince, une couche de polysilicium dopé, une couche de passivation ou une couche de pérovskites. Une couche mince désigne ici une couche d'épaisseur inférieure à 200 nm. Le dépôt de la couche mince est de préférence conforme. Une couche ultra-mince désigne une couche d'épaisseur inférieure à 3 nm.

Un troisième aspect de l'invention concerne un substrat en silicium cristallin s'étendant suivant un premier plan et comprenant une surface structurée, la surface structurée présentant des motifs comprenant chacun une base, un sommet et une surface latérale reliant le sommet à la base. Ce substrat est remarquable en ce que :

- la base de chaque motif est circulaire et présente un diamètre compris entre 300 nm et 800 nm ;
- chaque motif présente une hauteur suivant une direction normale au premier plan comprise entre 70 nm et 900 nm ; et
- les motifs présentent une densité surfacique comprise entre $2.10^6$ $mm^{-2}$ et $1,4.10^7$ $mm^{-2}$.

Outre les caractéristiques qui viennent d'être évoquées dans les paragraphes précédents, le substrat en silicium cristallin selon le troisième aspect de l'invention peut présenter une ou plusieurs caractéristiques complémentaires parmi les suivantes, considérées individuellement ou selon toutes les combinaisons techniquement possibles :

- le sommet de chaque motif présente un rayon de courbure compris entre 150 nm et 1200 nm dans un deuxième plan perpendiculaire au premier plan ;
- chaque motif présente un angle compris entre 30° et 50° entre sa base et sa surface latérale ; et

- les bases des motifs sont coplanaires.

Un quatrième aspect de l'invention concerne une cellule photovoltaïque comprenant un substrat en silicium cristallin selon le troisième aspect de l'invention.

La surface structurée du substrat peut être destinée à être exposée à un rayonnement électromagnétique incident ou à un rayonnement électromagnétique réfléchi ou diffus.

Dans un premier mode de réalisation, la cellule photovoltaïque comprend une couche d'oxyde de silicium ultra-mince disposée sur la surface structurée du substrat, une couche de silicium polycristallin dopé disposée sur la couche d'oxyde de silicium ultra-mince, une couche de passivation disposée sur la couche de silicium polycristallin dopé et une pluralité d'électrodes disposées en contact avec la couche de silicium polycristallin dopé à travers la couche de passivation. Une couche ultra-mince désigne une couche d'épaisseur inférieure à 3 nm.

Dans un deuxième mode de réalisation, la cellule photovoltaïque comprend une couche de passivation disposée sur la surface structurée du substrat, une couche de silicium amorphe dopé disposée sur la couche de passivation et une couche d'oxyde transparent conducteur disposée sur la couche de silicium amorphe dopé.

Dans un troisième mode de réalisation, la cellule photovoltaïque comprend sous-cellule photovoltaïque à base de silicium cristallin, à laquelle appartient le substrat en silicium cristallin, et une sous-cellule photovoltaïque à pérovskites disposée sur la surface structurée du substrat. La sous-cellule photovoltaïque à base de silicium cristallin peut être à homojonction ou à hétérojonction de silicium.

L'invention et ses différentes applications seront mieux comprises à la lecture de la description qui suit et à l'examen des figures qui l'accompagnent.

## BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

[Fig. 1], précédemment décrite, représente une cellule photovoltaïque à homojonction selon l'art antérieur, réalisée à partir d'un substrat en silicium cristallin et comprenant une structure de contact passivé ;

[Fig. 2] représente un mode de réalisation préférentiel d'un substrat en silicium cristallin selon un aspect de l'invention ;

[Fig. 3] représente schématiquement un motif présent en surface du substrat en silicium cristallin de la figure 2 ;

[Fig. 4] représente la réflectivité de trois substrats présentant des morphologies de surface différentes, dont un exemple de substrat en silicium cristallin selon un aspect de l'invention ;

[Fig. 5] représente la tension de circuit ouvert implicite de trois structures multicouches formées à partir des mêmes substrats, à différents stades de la fabrication de ces structures multicouches ;

[Fig. 6] représente la résistivité de contact d'électrodes formées par sérigraphie de deux pâtes métalliques sur les trois structures multicouches ;

[Fig. 7] représente schématiquement un exemple de réalisation d'une cellule photovoltaïque selon un aspect de l'invention ; et

[Fig. 8] représente schématiquement un autre exemple de réalisation d'une cellule photovoltaïque selon un aspect de l'invention.

Sur l'ensemble des figures, les éléments identiques ou similaires sont repérés par des signes de référence identiques.

## DESCRIPTION DETAILLEE

La figure 2 est une vue en perspective d'un substrat en silicium cristallin 20 selon un mode de réalisation préférentiel de l'invention. Ce substrat 20 peut notamment être utilisé pour fabriquer une cellule photovoltaïque en silicium. Le silicium du substrat 20 peut être monocristallin ou polycristallin. Il peut être intrinsèque ou au contraire dopé, de type n ou de type p.

Le substrat 20 s'étend suivant des première et deuxième directions (dites « principales ») x et y, qui définissent un premier plan P1, et une troisième direction z dite « secondaire », perpendiculaire au premier plan P1. L'épaisseur du substrat 20, mesurée suivant la troisième direction z, est inférieure ou égale à 700 $\mu$m, par exemple comprise entre 70 $\mu$m et 250 $\mu$m.

Le substrat 20 comprend une première surface 20A et une deuxième surface 20B opposée à la première surface 20A. À l'échelle macroscopique, les première et deuxième surfaces 20A-20B du substrat 20 sont planes et parallèles entre elles. Elles sont destinées à former des faces avant et arrière de la cellule photovoltaïque.

La première surface 20A du substrat 20 est structurée, afin de diminuer sa réflectivité. Elle présente des motifs 30 en saillie. Les motifs 30 sont des protubérances qui s'étendent dans une direction sensiblement perpendiculaire au premier plan P1 (c.-à-d. à 90° $\pm$ 10 %). La densité surfacique des motifs 30 de la première surface 20A est comprise entre $2{,}0.10^6$ $mm^{-2}$ et $1{,}4.10^7$ $mm^{-2}$, de préférence entre $3{,}5.10^6$ $mm^{-2}$ et $8.10^6$ $mm^{-2}$, étant considéré que les motifs 30 peuvent se chevaucher. La première surface 20A est avantageusement une surface destinée à exposée (directement ou indirectement) à un rayonnement électromagnétique, tel que le rayonnement solaire.

Dans le mode de réalisation préférentiel de la figure 2, les motifs 30 sont juxtaposés et n'ont pas les mêmes dimensions, ni la même forme. En particulier, certains motifs 30 sont plus allongés que d'autres.

Néanmoins, chaque motif 30 de la première surface 20A comprend une base 31 circulaire ou sensiblement circulaire, un sommet 32 et une surface latérale 33 reliant le sommet 32 à la base 31. Les bases 31 des motifs 30 sont de préférence coplanaires et toutes situées dans le premier plan P1.

La figure 3 est une vue en coupe d'un des motifs 30 de la figure 2 selon un deuxième plan P2 perpendiculaire au premier plan P1.

Le diamètre moyen D de chaque base 31 est compris entre 300 nm et 800 nm, de préférence entre 400 nm et 600 nm. A titre de comparaison, les pyramides de la surface texturée selon l'art antérieur comprennent une base carrée dont les côtés ont une longueur comprise entre 1 $\mu$m et 4 $\mu$m, généralement voisine de 2 $\mu$m.

Chaque motif 30 présente par ailleurs une hauteur H suivant une direction normale au premier plan P1 comprise entre 70 nm et 900 nm, préférentiellement entre 100 nm et 350 nm. La hauteur H d'un motif est la distance minimale (c.-à-d. suivant la direction normale au premier plan P1) qui sépare la base 31 et le sommet 32 du motif. A titre de comparaison, les pyramides de la surface texturée selon l'art antérieur présentent une hauteur comprise entre 0,7 $\mu$m et 2,9 $\mu$m, typiquement autour de 1,4 $\mu$m.

Les caractéristiques morphologiques qui viennent d'être mentionnées, à savoir la forme et la taille de la base 31 des motifs 30, la hauteur et la densité surfacique des motifs 30, confèrent à la première surface 20A d'excellentes propriétés en termes de réflectivité (cf. Fig.4), de passivation (cf. Fig.5) et de résistance de contact (cf. Fig.6). Ces propriétés seront décrites plus en détail en relation avec les figures 4 à 6 et un exemple de réalisation du substrat en silicium cristallin 20.

Toujours en référence à la figure 3, la surface latérale 33 de chaque motif 30 s'étend depuis sa base 31 jusqu'à son sommet 32. Au départ de la base 31, la surface latérale 33 est de préférence orientée par rapport à la base 31 d'un angle $\alpha$ compris entre 30° et 50°, de préférence entre 40° et 45°. A titre de comparaison, les pyramides de la surface texturée selon l'art antérieur comprennent des flancs qui forment un angle d'environ 54,7° avec leur base carrée.

Par ailleurs, le sommet 32 de chaque motif 30 présente avantageusement un rayon de courbure compris entre 150 nm et 1200 nm (inférieur à 30 nm dans le cas des pyramides). Un tel rayon de courbure rend possible l'obtention de couches minces d'épaisseur sensiblement constante ($\pm$ 10 %) et sans discontinuité sur la première surface 20A, contrairement à une surface texturée sous forme de pyramides (dans laquelle les sommets des pyramides sont plus abrupts, et donc plus « saillants », occasionnant des ruptures de couches minces, et dans laquelle les fonds de vallée générés par les pyramides constituent des zones d'accumulation de matière lors d'un dépôt de couche mince).

Un angle $\alpha$ entre la base 31 et la surface latérale 33 et/ou un rayon de courbure au sommet 32 dans les plages de valeurs susmentionnées améliorent encore les propriétés de la première surface 20A en termes de réflectivité, de passivation et résistance de contact.

La première surface 20A structurée est obtenue en accomplissant un procédé de formation de motifs à la surface d'un substrat en silicium cristallin. Ce substrat, aussi appelé « plaquette », a été au préalable découpé (par exemple par sciage) dans un lingot de silicium cristallin. Les deux faces principales du substrat présentent alors un état brut de découpage, caractérisé par des stries et/ou des microfissures, et une contamination par des particules métalliques et/ou organiques.

Le procédé de formation de motifs peut comporter initialement une étape de gravure d'une zone écrouie présente en surface du substrat. Cette gravure vise à supprimer les stries et/ou les microfissures dues au découpage et à éliminer les particules métalliques et/ou organiques présentes à la surface du substrat, rétablissant ainsi une surface propice à la réalisation d'une cellule photovoltaïque. La gravure de la zone écrouie peut être accomplie par polissage chimique de la surface, en milieu basique ou acide, par exemple dans une solution aqueuse d'hydroxyde de potassium (KOH) de concentration massique comprise entre 15 % et 25 %, ou par planarisation mécano-chimique (ou CMP, pour « Chemical-Mechanical Planarization » en anglais).

Le procédé de formation de motifs comporte ensuite une étape de structuration consistant à immerger une surface du substrat dans un bain de gravure (anisotrope) comprenant une solution aqueuse d'hydroxyde de potassium (KOH).

Les conditions opératoires de cette étape de structuration, à savoir la durée d'immersion, la concentration massique en hydroxyde de potassium (KOH) du bain de gravure et la température du bain de gravure, sont choisies de façon à obtenir des motifs 30 présentant les caractéristiques morphologiques susmentionnées (en particulier une base circulaire ou sensiblement circulaire présentant un diamètre moyen compris entre 300 nm et 800 nm, une hauteur comprise entre 70 nm et 900 nm et une densité surfacique comprise entre $2.10^6$ $mm^{-2}$ et $1,4.10^7$ $mm^{-2}$).

Ces conditions opératoires peuvent être déterminées au moyen d'un plan d'expérience. Dans ce plan d'expérience, plusieurs substrats de test sont soumis à l'étape de structuration, en faisant varier au moins l'une des conditions opératoires d'un substrat de test à l'autre. La forme et les dimensions des motifs obtenus à la surface des substrats de test à l'issue de l'étape de structuration peuvent être déterminées directement à partir d'images de la surface structurée prises au microscope électronique à balayage. La densité surfacique d des motifs peut être calculée sensiblement de la même façon que la densité surfacique des pyramides :

[Math. 1]

$$d = \frac{N}{S}$$

où S est la superficie de la surface considérée et N le nombre de motifs compris dans cette surface.

La superficie S peut être estimée de la façon suivante :

[Math. 2]

$$S = N \times \pi \frac{D^2}{4}$$

où D est le diamètre moyen de la base des motifs.

On obtient alors :

[Math. 3]

$$d = \frac{4}{\pi D^2}$$

Des essais ont montré que, en partant d'une plaquette dont la zone écrouie a été retirée, la première surface 20A structurée pouvait être obtenue dans les conditions suivantes :

- une concentration massique en hydroxyde de potassium (KOH) du bain de gravure comprise entre 0,95 % et 1,05 % ;
- une température du bain de gravure comprise entre 60 °C et 80 °C ; et
- une durée d'immersion comprise entre 8 minutes et 12 minutes.

Le bain de gravure peut être préparé en diluant, par exemple avec de l'eau déionisée, un volume de solution (dite de départ) d'hydroxyde de potassium (KOH) de concentration massique égale à 44 % et de densité égale à 1,43 $g/cm^3$.

Le bain de gravure peut également comprendre un surfactant, afin d'améliorer la mouillabilité du substrat et la sélectivité de gravure. La concentration volumique du surfactant dans le bain de gravure est avantageusement comprise entre 1,9 % et 2,2 %. De préférence, le surfactant utilisé est l'un de ceux décrits dans le document [« New surfactants

for combined cleaning and texturing of mono-crystalline silicon wafers after wire-sawing », K. Mayer et al., 23rd European Photovoltaic Solar Energy Conférence, pp.1109-1113, 2008]. Il peut comprendre des molécules présentant l'une des formules suivantes :

[Chem. 1]

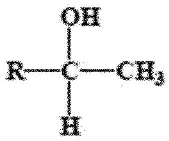

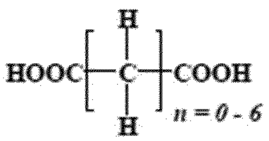

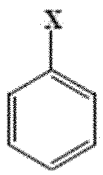

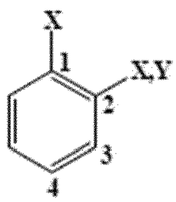

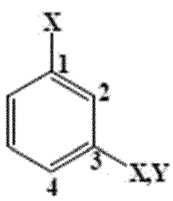

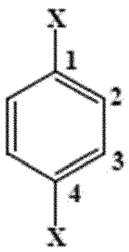

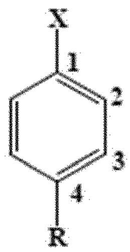

où « R » désigne un groupe aliphatique, par exemple un groupe alkyle, « X » et « Y » désignent des groupes polaires, par exemple des groupes hydroxyle ou carboxyle.

Le surfactant du bain de gravure est par exemple celui commercialisé par la société ICB GmbH & Co. KG sous la référence « CellTex ULTRA ».

Le bain de gravure est avantageusement recirculé afin d'améliorer l'uniformité de la structuration.

Comme indiqué précédemment, la structuration de la surface peut être effectuée sur une plaquette de silicium dont la zone écrouie a été préalablement retirée. Alternativement, la structuration de la surface peut être effectuée en partant d'une plaquette brute de sciage, autrement dit en plongeant une plaquette brute de sciage dans le bain utilisé pour la structuration. On veillera alors (en augmentant le temps d'immersion) à graver suffisamment de silicium lors de la formation des motifs 30 pour permettre également le retrait de la zone écrouie. Avec la chimie décrite précédemment, la vitesse de gravure du silicium avoisine 0,2 μm/min/face. Un temps d'immersion d'environ 35 minutes dans le bain de KOH à 70°C avec surfactant permet de retirer une zone écrouie d'environ 7 μm d'épaisseur et de former simultanément les motifs 30.

De nouveau en référence à la figure 2, la deuxième surface 20B du substrat 20 peut présenter une texturation de surface (sous la forme de pyramides), un état de surface poli ou un état de surface brut de découpage, si aucune étape de préparation de surface n'est accomplie après avoir découpé le substrat. Alternativement, la deuxième surface 20B peut être structurée de la même façon que la première surface 20A en appliquant le procédé de formation de motifs simultanément aux deux surfaces (c.-à-d. en plongeant entièrement le substrat dans le bain et ne protégeant pas la deuxième surface 20B).

La figure 4 représente la réflectivité d'un exemple de réalisation du substrat en silicium cristallin 20 selon l'invention, dénommé « POTEX », en fonction de la longueur d'onde du rayonnement électromagnétique dirigé vers la première surface 20A. Dans cet exemple de réalisation, la structuration de la première surface 20A a été accomplie grâce à une étape de polissage dans une solution de KOH à 20 % massique suivie d'une étape de structuration pendant 10 min dans un bain de gravure recirculé à 70 °C. Le bain de gravure comprend du KOH à 1 % massique et le surfactant « CellTex ULTRA » à 2,1 % en volume. La figure 4 représente également, à titre de comparaison, la réflectivité d'un premier substrat de référence, dénommé « REF Texturée » et comprenant une surface texturée sous forme de pyramides

selon un procédé de l'art antérieur (KOH à 3,1% massique, surfactant 0,44% en volume pendant 15 min à 80°C sur plaquettes brutes de sciage) et la réflectivité d'un deuxième substrat de référence, dénommé « REF Polie » et comprenant une surface polie selon un autre procédé de l'art antérieur (KOH à 20 % massique pendant 6 min à 80°C sur plaquettes brutes de sciage).

On constate que la première surface 20A du substrat en silicium cristallin 20 constitue, en termes de réflectivité à des longueurs d'onde comprises entre 300 nm et 1000 nm, un intermédiaire entre la surface texturée sous forme de pyramides et la surface polie.

La figure 5 représente la tension de circuit ouvert implicite i-Voc de structures multicouches appelées « précurseurs de cellule photovoltaïque » et formées à partir des mêmes substrats « POTEX », « REF Texturée » et « REF Polie ». La tension de circuit ouvert implicite i-Voc correspond à la valeur maximale de la tension de circuit ouvert Voc que pourra atteindre la cellule photovoltaïque (après métallisation des structures). La formation de ces structures multicouches comprend successivement une étape de nettoyage des surfaces comprenant une croissance d'oxyde de silicium par voie chimique, le dépôt par LPCVD (« Low Pressure Chemical Vapor Déposition » en anglais) d'une couche d'oxyde de silicium ultra-mince puis d'une couche de silicium polycristallin sur chacune des faces des substrats, le dépôt par PECVD (« Plasma-Enhanced Chemical Vapor Déposition ») d'une couche de passivation en nitrure de silicium hydrogéné sur chacune des couches de silicium polycristallin, une étape de recuit et la formation d'électrodes par sérigraphie d'une pâte d'argent sur chacune des couches de passivation.

La tension de circuit ouvert implicite i-Voc est mesurée à différents stades de la formation des structures multicouches : après dépôt des couches de silicium polycristallin, après dépôt des couches de passivation en SiN et après recuit.

La figure 5 montre que la tension de circuit ouvert implicite i-Voc après recuit de la structure comprenant le substrat en silicium cristallin « POTEX » est comparable à celle de la structure comprenant le substrat de référence poli « REF Polie » et supérieure à celle de la structure comprenant le substrat de référence texturé « REF Texturée ». Cela signifie que le substrat en silicium cristallin « POTEX » présente des propriétés de passivation aussi bonnes qu'un substrat dont les surfaces ont été polies.

La figure 6 représente la résistivité de contact des électrodes formées par sérigraphie, en utilisant deux pâtes d'argent distinctes. La résistivité de contact des électrodes disposées sur le substrat en silicium cristallin « POTEX » est comparable à celle des électrodes disposées sur le substrat de référence texturé « REF Texturée » et bien inférieure à celle des électrodes disposées sur le substrat de référence poli « REF Polie ». Ce constat est valable quelle que soit la pâte d'argent utilisée. On observe en outre l'absence d'arrachement des électrodes dans le cas du substrat en silicium cristallin « POTEX », contrairement au cas du substrat de référence poli « REF Polie ».

Compte tenu de ses bonnes propriétés en termes de réflectivité, de passivation et de prise de contact, le substrat en silicium cristallin 20 peut être avantageusement utilisé pour fabriquer une cellule photovoltaïque. La première surface 20A structurée du substrat 20 peut être destinée à recevoir un rayonnement incident (ou direct) et donc correspondre à la face avant de la cellule photovoltaïque. Alternativement, la première surface 20A structurée peut être destinée à recevoir un rayonnement réfléchi ou diffus (autrement dit indirect) et donc correspondre à la face arrière de la cellule photovoltaïque (qui est opposée à la face avant).

La fabrication de la cellule photovoltaïque comporte, outre la mise en oeuvre du procédé de formation des motifs 30 sur au moins une des surfaces du substrat, le dépôt d'une ou plusieurs couches minces sur la surface structurée. On peut citer à titre d'exemple une couche d'oxyde de silicium ultra-mince, une couche de polysilicium dopé, une couche de passivation, un revêtement antireflet ou une couche de pérovskites. Ces couches minces sont de préférence déposées de manière conforme. Les motifs 30 de la surface structurée facilitent l'obtention de couches minces (ou ultra-minces) d'épaisseur sensiblement constante (sans discontinuité et sans accumulation de matière), en particulier lorsqu'une technique de dépôt par voie chimique est utilisée, par exemple le dépôt par centrifugation (« spin-coating » en anglais) ou par enduction (« slot-die »).

Selon un premier exemple de réalisation, la cellule photovoltaïque fabriquée à partir du substrat en silicium cristallin 20 est une cellule à homojonction de silicium bifaciale comprenant en face arrière une structure de contact passivé à oxyde tunnel (structure dite « TOPCon »). Comme décrit précédemment en relation avec la figure 1, cette cellule à homojonction peut comprendre, outre le substrat 20 dopé de type n ou de type p (les références numériques de la figure 1 sont reprises ci-dessous, à l'exception de celle du substrat) :

- une couche d'oxyde de silicium 11 (appelé « oxyde ultra-mince ») d'épaisseur très faible (inférieure à 3 nm) disposée sur la première surface 20A structurée du substrat 20 ;

- une couche de silicium polycristallin dopé 12 disposée sur la couche d'oxyde 11 ;

- une première couche de passivation, par exemple en nitrure de silicium ($SiN_x$) hydrogéné, disposée sur la couche de silicium polycristallin dopé 12 ;

- une pluralité de premières électrodes 13 discrètes et en contact avec la couche de silicium polycristallin dopé 12 à travers la première couche de passivation ;

- une couche émetteur 14 en silicium dopé (de type opposé à celui du substrat 20) disposée sur la deuxième surface 20B du substrat 20 :

- une deuxième couche de passivation 15, par exemple en alumine ($Al_2O_3$), disposée sur la couche émetteur 14 ;

- un revêtement antireflet 16, par exemple en nitrure de silicium (SiN), disposé sur la deuxième couche de passivation 15 ; et

- une pluralité de deuxièmes électrodes 17, discrètes et en contact avec la couche émetteur 14 à travers la deuxième couche de passivation 15 et le revêtement antireflet 16.

La première couche de passivation sert avantageusement de revêtement antireflet et à hydrogéner le silicium polycristallin lors du recuit des électrodes.

La deuxième face 20B du substrat 20, correspondant ici à la face avant de la cellule photovoltaïque, est avantageusement texturée sous la forme de pyramides.

La figure 7 montre un deuxième exemple de cellule photovoltaïque pouvant être obtenue à partir du substrat en silicium cristallin 20 : celui d'une cellule à hétérojonction de silicium 80. La cellule à hétérojonction de silicium 80 peut comprendre (outre le substrat en silicium cristallin 20) :

- une première couche de passivation 81A, par exemple en silicium amorphe intrinsèque hydrogéné, disposée sur la première surface 20A structurée du substrat 20 ;

- une première couche de silicium amorphe 82A, disposée sur la première couche de passivation 81A et dopée d'un premier type de conductivité (de préférence du même type que le substrat en silicium cristallin 20) ;

- une première couche d'oxyde transparent conducteur 83A disposée sur la première couche de silicium amorphe 82A ;

- une pluralité de premières électrodes 84A, discrètes et en contact avec la première couche d'oxyde transparent conducteur 83A ;

- une deuxième couche de passivation 81B, par exemple en silicium amorphe intrinsèque hydrogéné, disposée sur la deuxième surface 20B du substrat 20 ;

- une deuxième couche de silicium amorphe 82B, disposée sur la deuxième couche de passivation 81B et dopée d'un deuxième type de conductivité opposé au premier type de conductivité ;

- une deuxième couche d'oxyde transparent conducteur 83B disposée sur la deuxième couche de silicium amorphe 82B ;

- une pluralité de deuxièmes électrodes 84B, discrètes et en contact avec la deuxième couche d'oxyde transparent conducteur 83B.

Le silicium amorphe des première et deuxièmes couches dopées 82A-82B est de préférence hydrogéné.

La première surface 20A structurée du substrat 20 correspond avantageusement à la face arrière de la cellule photovoltaïque à hétérojonction de silicium 80. La deuxième surface 20B du substrat 20, correspondant à la face avant de la cellule photovoltaïque, est avantageusement texturée sous la forme de pyramides.

Enfin, la figure 8 représente un troisième exemple de cellule photovoltaïque, celui d'une cellule photovoltaïque tandem 90. La cellule photovoltaïque tandem 90 comprend une sous-cellule photovoltaïque à pérovskites 100 disposée sur une sous-cellule à base de silicium cristallin. La sous-cellule à base de silicium cristallin peut être une cellule à homojonction de silicium ou une cellule à hétérojonction de silicium, par exemple la cellule à hétérojonction de silicium 80 de la figure 7. Elle comprend le substrat en silicium cristallin 20. La sous-cellule photovoltaïque à pérovskites 100 comprend des couches minces de pérovskites (épaisseur de préférence inférieure à 50 nm) disposées sur la première surface 20A structurée du substrat 20. Les couches minces de pérovskites sont avantageusement déposées par voie chimique, par exemple par centrifugation (« spin-coating » en anglais) ou enduction (« slot-die »). Dans l'exemple de la

figure 8, la sous-cellule photovoltaïque à pérovskites 100 est formée entre le dépôt de la première couche d'oxyde transparent conducteur 83A et la formation des premières électrodes 84A.

La première surface 20A structurée du substrat 20 correspond avantageusement à la face avant de la sous-cellule photovoltaïque à base de silicium cristallin, sur laquelle est disposée la sous-cellule photovoltaïque à pérovskites 100. La deuxième surface 20B du substrat 20, correspondant à la face arrière de la sous-cellule photovoltaïque à base de silicium cristallin (et donc à la face arrière de la cellule photovoltaïque tandem 90), est avantageusement structurée de la même façon que la première surface 20A.

Dans les exemples de cellule photovoltaïque décrits ci-dessus, les premières électrodes 13, 84A et les deuxièmes électrodes 17, 84B sont avantageusement formées par sérigraphie d'une pâte métallique, par exemple une pâte d'argent. Elles sont aussi appelées « doigts de collecte ».

## Revendications

1. Procédé de formation de motifs (30) à la surface (20A) d'un substrat en silicium cristallin (20), le procédé comprenant une étape de structuration consistant à immerger la surface (20A) du substrat (20) dans un bain de gravure comprenant une solution aqueuse d'hydroxyde de potassium (KOH) et dans lequel la concentration massique en hydroxyde de potassium (KOH) du bain de gravure est comprise entre 0,95 % et 1,05 %, la température du bain de gravure est comprise entre 60 °C et 80 °C et la durée d'immersion est comprise entre 8 minutes et 12 minutes.

2. Procédé selon la revendication 1, comprenant, avant l'étape de structuration, une étape de gravure d'une zone écrouie présente à la surface (20A) du substrat (20).

3. Procédé selon la revendication 1, dans lequel la durée d'immersion est en outre choisie de sorte à graver simultanément une zone écrouie présente à la surface du substrat.

4. Procédé selon l'une des revendications 1 à 3, dans lequel le bain de gravure comprend un surfactant de concentration volumique comprise entre 1,9 % et 2,2 %.

5. Procédé de fabrication d'une cellule photovoltaïque (80, 90), comprenant une étape de formation de motifs (30) à la surface (20A) d'un substrat en silicium cristallin (20) par mise en oeuvre d'un procédé de formation selon l'une quelconque des revendications 1 à 4.

6. Procédé de fabrication selon la revendication 5, comprenant en outre une étape de dépôt d'une couche mince sur la surface du substrat, par exemple une couche d'oxyde de silicium (11) d'épaisseur inférieure à 3 nm, une couche de polysilicium dopé (12), une couche de passivation (81A) ou une couche de pérovskites.

## Patentansprüche

1. Verfahren zur Bildung von Mustern (30) auf der Oberfläche (20A) eines kristallinen Siliziumsubstrats (20), wobei das Verfahren einen Strukturierungsschritt umfasst, bei dem die Oberfläche (20A) des Substrats (20) in ein Ätzbad getaucht wird, das eine wässrige Lösung aus Kaliumhydroxid (KOH) umfasst, und in dem die Massenkonzentration von Kaliumhydroxid (KOH) in dem Ätzbad zwischen 0,95% und 1,05% beträgt, die Temperatur des Ätzbades zwischen 60°C und 80 °C liegt und die Eintauchzeit zwischen 8 Minuten und 12 Minuten beträgt.

2. Verfahren nach Anspruch 1, das vor dem Schritt der Strukturierung einen Schritt des Ätzens eines kaltverfestigten Bereichs umfasst, der auf der Oberfläche (20A) des Substrats (20) vorhanden ist.

3. Verfahren nach Anspruch 1, bei dem die Eintauchzeit zusätzlich so gewählt wird, dass gleichzeitig ein auf der Oberfläche des Substrats vorhandener kaltverfestigter Bereich geätzt wird.

4. Verfahren nach einem der Ansprüche 1 bis 3, bei dem das Ätzbad ein Tensid mit einer Volumenkonzentration zwischen 1,9 % und 2,2 % umfasst.

5. Verfahren zur Herstellung einer Fotovoltaikzelle (80, 90), umfassend einen Schritt zur Bildung von Mustern (30) auf der Oberfläche (20A) eines kristallinen Siliziumsubstrats (20) durch Ausführen eines Bildung sverfahrens nach einem der Ansprüche 1 bis 4.

6. Herstellungsverfahren nach Anspruch 5, das außerdem einen Schritt des Auftragens einer dünnen Schicht auf der Oberfläche des Substrats umfasst, z. B. eine Siliziumoxidschicht (11) mit einer Dicke von weniger als 3 nm, eine Schicht aus dotiertem Polysilizium (12), eine Passivierungsschicht (81A) oder eine Schicht aus Perowskiten.

**Claims**

1. Method for forming patterns (30) on the surface (20A) of a crystalline silicon substrate (20), the method comprising a structuring step consisting in immersing the surface (20A) of the substrate (20) in an etching bath (5) comprising an aqueous solution of potassium hydroxide (KOH) and wherein the mass concentration of potassium hydroxide (KOH) in the etching bath is between 0.95% and 1.05%, the temperature of the etching bath is between 60°C and 80°C and the immersion time is between 8 minutes and 12 minutes.

2. Method according to claim 1, comprising, before the structuring step, a step of etching a strain-hardened zone present on the surface (20A) of the substrate (20).

3. Method according to claim 1, wherein the immersion time is further selected so as to simultaneously etch a strain-hardened zone present on the surface of the substrate.

4. Method according to one of claims 1 to 3, wherein the etching bath comprises a surfactant with a volume concentration between 1.9% and 2.2%.

5. Method for manufacturing a photovoltaic cell (80, 90), comprising a step of forming patterns (30) on the surface (20A) of a crystalline silicon substrate (20) by implementing a forming method according to any of claims 1 to 4.

6. Manufacturing method according to claim 5, further comprising a step of depositing a thin layer onto the surface of the substrate, for example a layer of silicon oxide (11) with a thickness of less than 3 nm, a layer of doped polysilicon (12), a passivation layer (81A) or a layer of perovskites.

**Fig. 1**

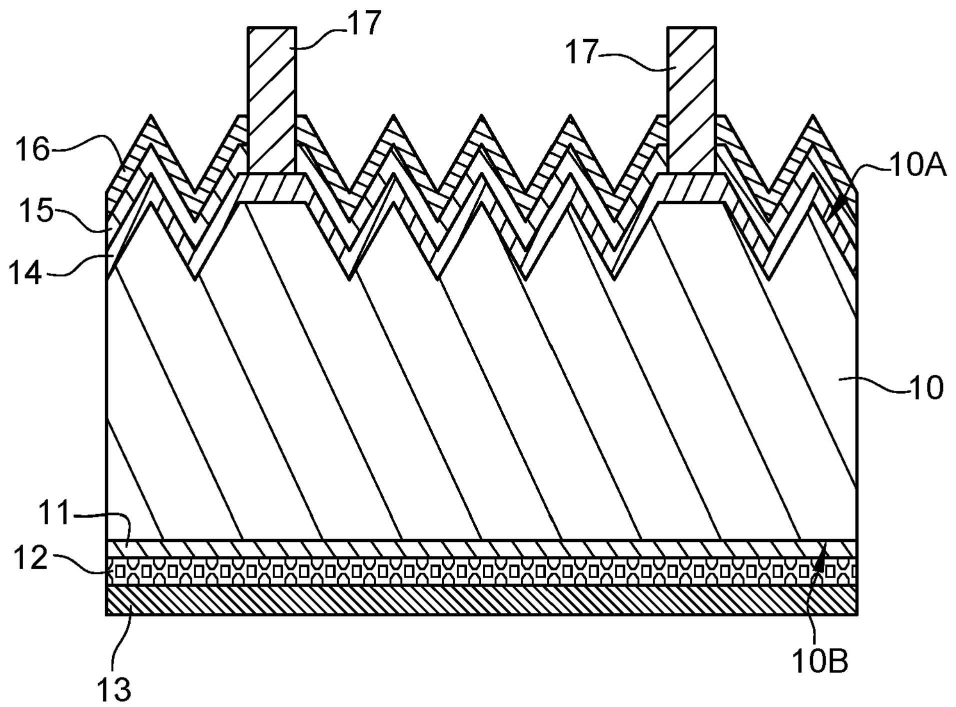
17
17
16
10A
15
14
10
11
12
13
10B

**Fig. 2**

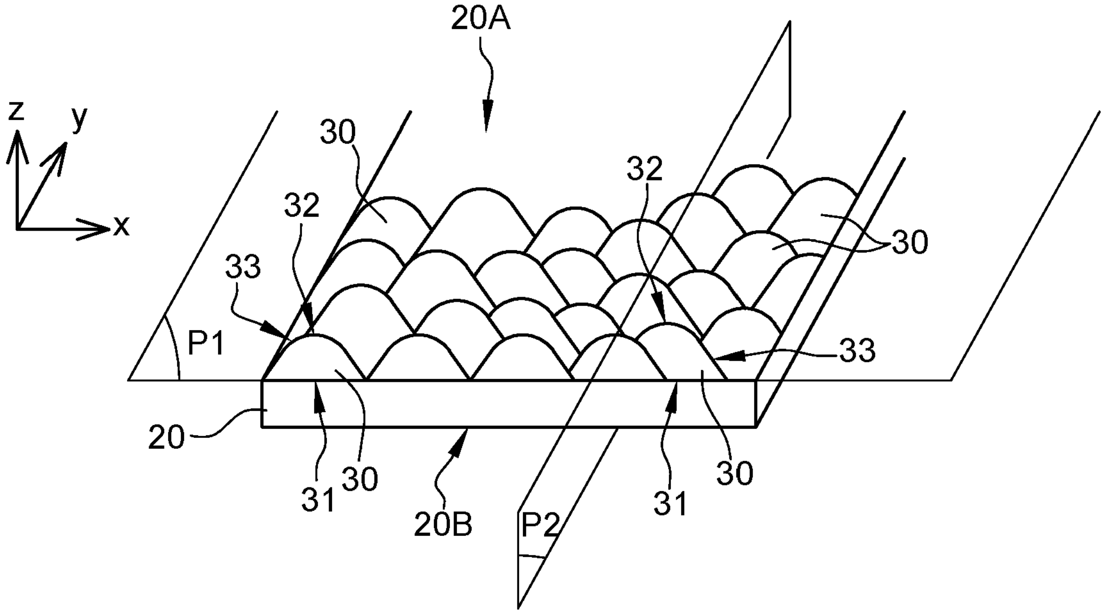
20A
z
y
x
30
32
33
P1
32
30
33
20
31
30
20B
P2
31
30

# Fig. 3

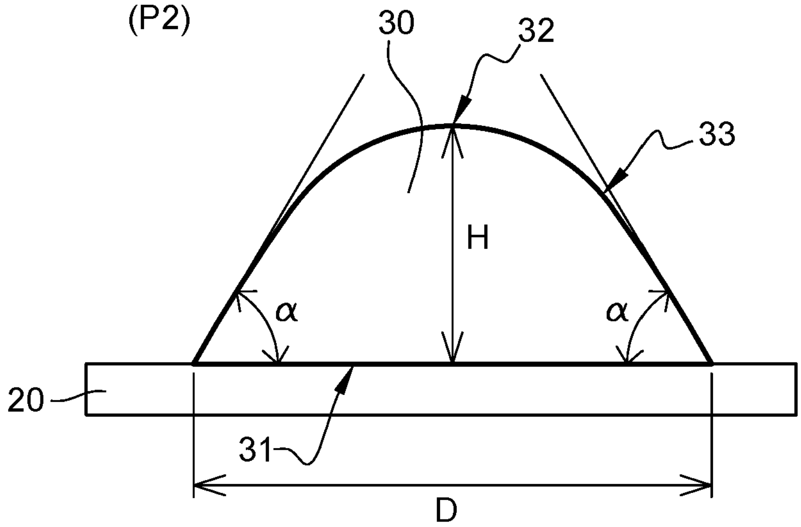
(P2)
30
32
33
H
α
α
20
31
D

# Fig. 4

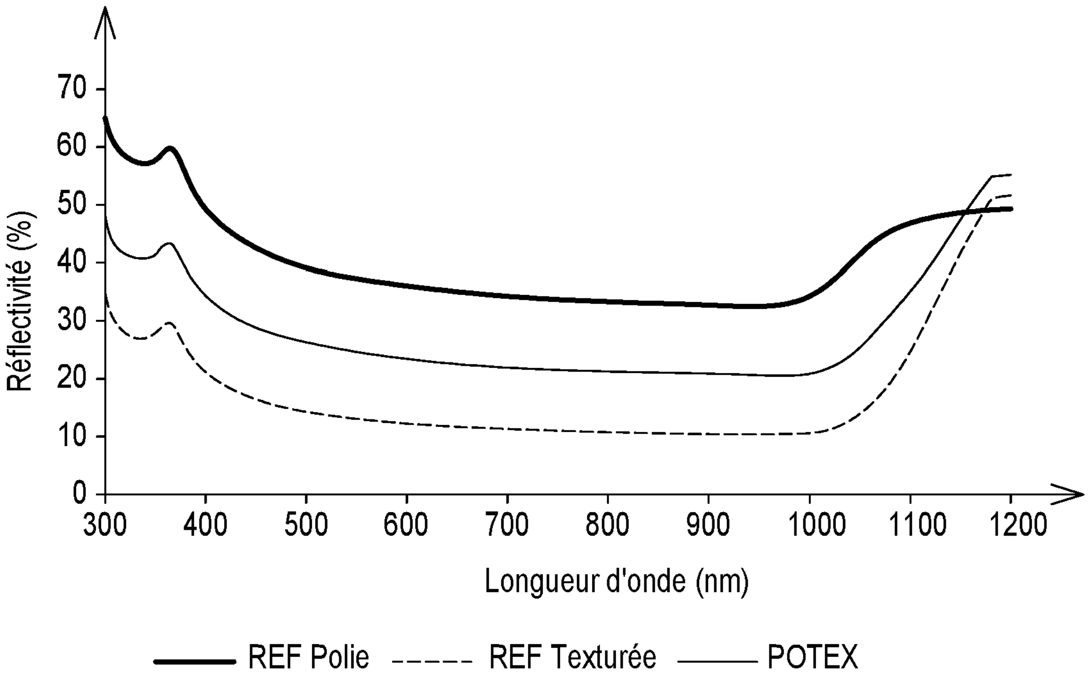
Réflectivité (%)
70
60
50
40
30
20
10
0
300
400
500
600
700
800
900
1000
1100
1200
Longueur d'onde (nm)
REF Polie
REF Texturée
POTEX

# Fig. 5

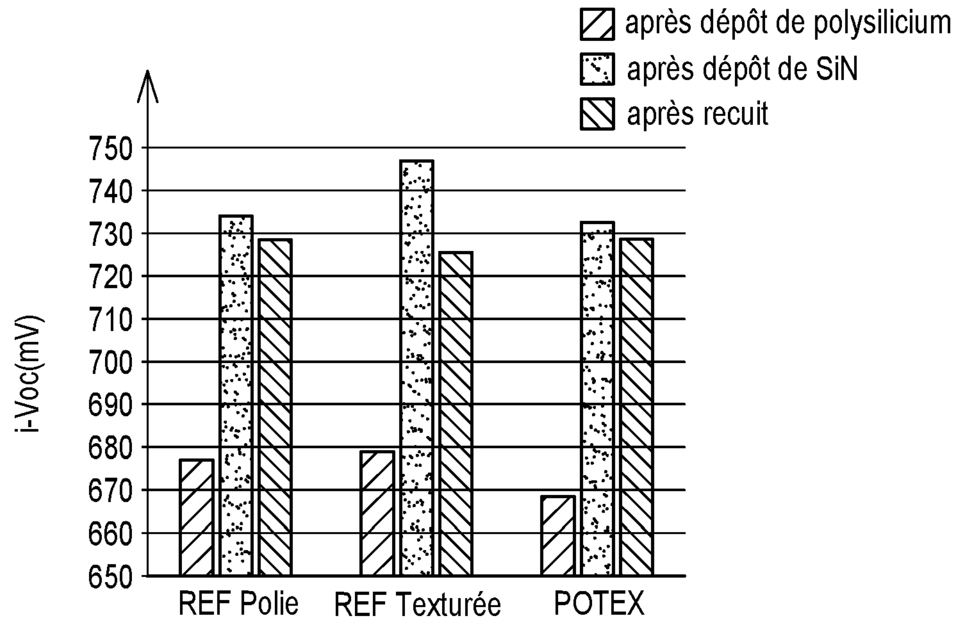
après dépôt de polysilicium
après dépôt de SiN
après recuit
i-Voc(mV)
750
740
730
720
710
700
690
680
670
660
650
REF Polie
REF Texturée
POTEX

# Fig. 6

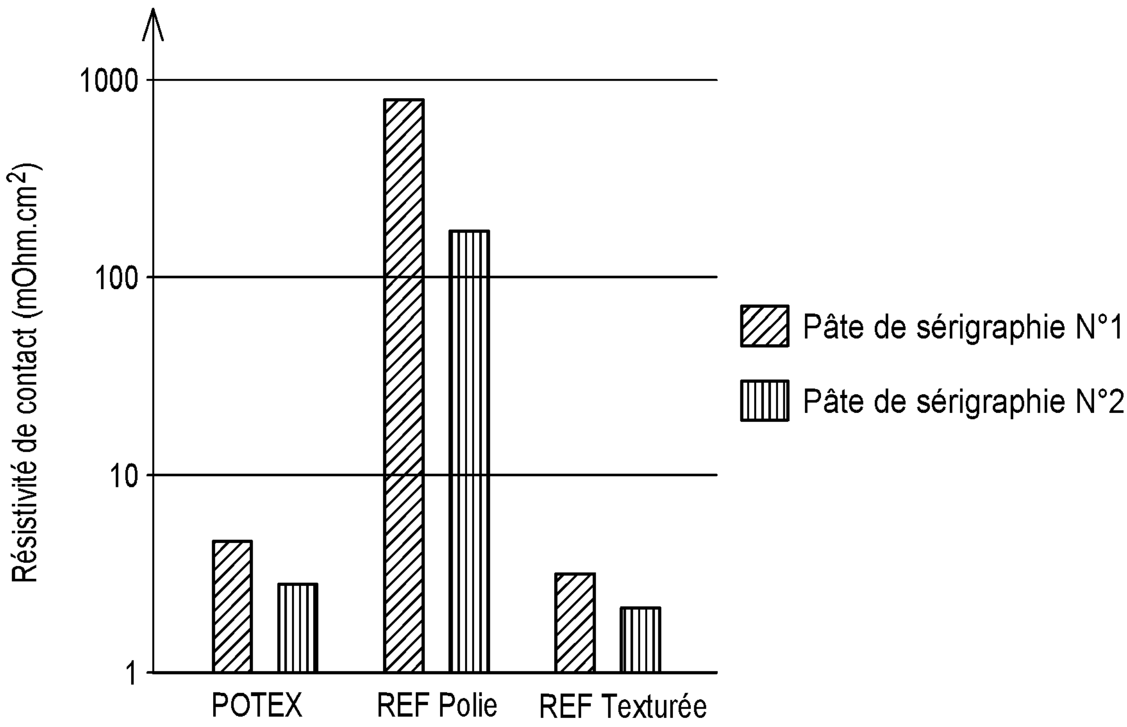
Résistivité de contact (mOhm.cm²)
1000
100
10
1
Pâte de sérigraphie N°1
Pâte de sérigraphie N°2
POTEX
REF Polie
REF Texturée

Fig. 7

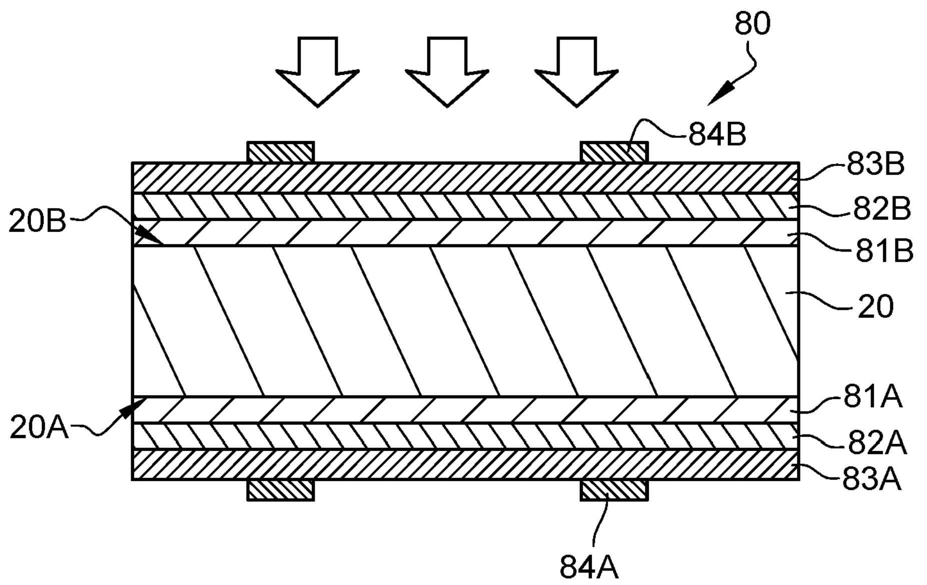
80
84B
83B
82B
81B
20
20B
81A
82A
83A
20A
84A

Fig. 8

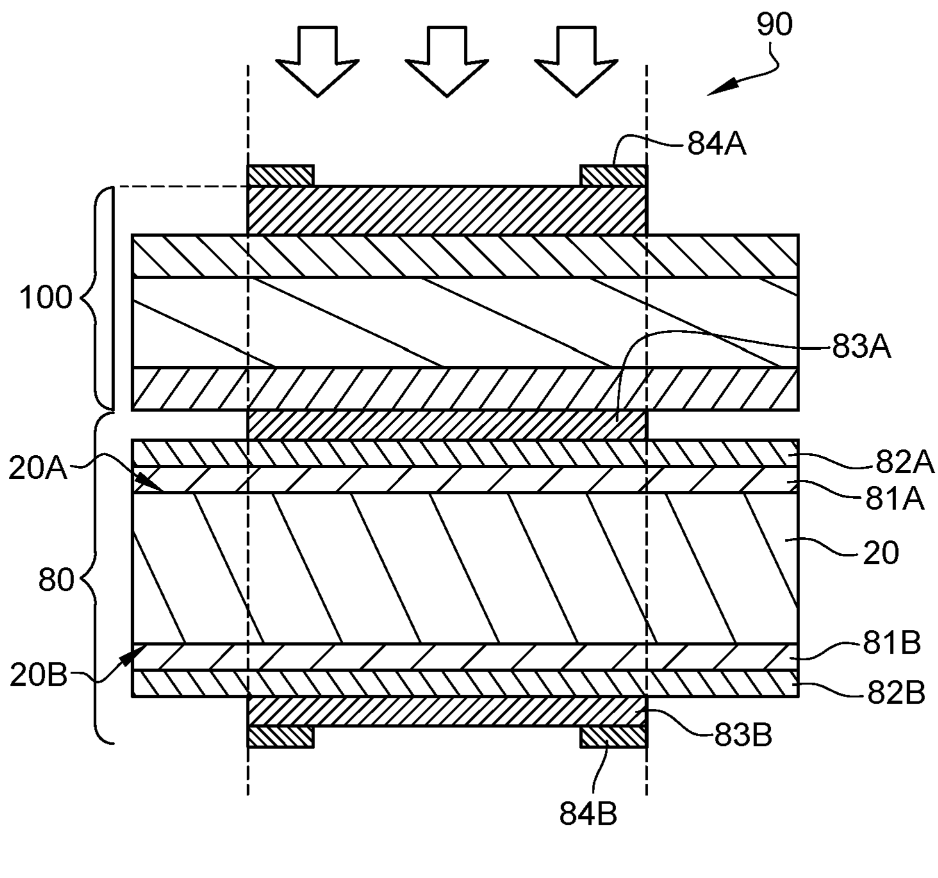
90
84A
100
83A
82A
81A
20A
20
80
81B
82B
20B
83B
84B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 2012112321 A1
- WO 2013055290 A1


### Littérature non-brevet citée dans la description


- **F. FELDMANN et al.** Passivated rear contacts for high-efficiency n-type Si solar cells providing high interface passivation quality and excellent transport characteristics. *Solar Energy Materials & Solar Cells,* 2014, vol. 120, 270-274
- **S. W. GLUNZ et al.** The irresistible charm of a simple current flow pattern-25% with a solar cell featuring a full-area back contact. *Proceedings of the 31 st European Photovoltaic Solar Energy Conférence and Exhibition,* 2015, 259-263
- **K. MAYER et al.** New surfactants for combined cleaning and texturing of mono-crystalline silicon wafers after wire-sawing. *23rd European Photovoltaic Solar Energy Conférence,* 2008, 1109-1113